# EUROPÄISCHE PATENTSCHRIFT

(11) **EP 1 264 004 B1**
(45) Veröffentlichungstag und Bekanntmachung des Hinweises auf die Patenterteilung: **03.08.2005**
(21) Anmeldenummer: 01929385.1
(22) Anmeldetag: 01.03.2001
(51) Int. Cl.: C23C 16/511, H01J 37/32

(54) **VERFAHREN UND VORRICHTUNG ZUR BESCHICHTUNG VON SUBSTRATEN**
METHOD AND DEVICE FOR COATING SUBSTRATES
PROCEDE ET DISPOSITIF POUR RECOUVRIR DES SUBSTRATS

(30) Priorität: 04.03.2000 DE 10010766
(43) Veröffentlichungstag der Anmeldung: 11.12.2002
(73) Patentinhaber: SCHOTT AG, 55122 Mainz (DE)
(72) Erfinder: DANIELZIK, Burkhard, 55411 Bingen (DE); KUHR, Markus, 55579 Wöllstein (DE); MÖHL, Wolfgang, 67550 Worms (DE)
(74) Vertreter: Mehler, Klaus, Dr. rer.nat.
(86) Internationale Anmeldenummer: PCT/EP2001/002333
(87) Internationale Veröffentlichungsnummer: WO 2001/066822

(56) Entgegenhaltungen:
- DE-A- 19 652 454
- US-A- 5 234 526
- US-A- 5 364 519
- PATENT ABSTRACTS OF JAPAN vol. 1996, no. 02, 29. Februar 1996 (1996-02-29) & JP 07 263348 A (HITACHI LTD;OTHERS: 01), 13. Oktober 1995 (1995-10-13)
- PATENT ABSTRACTS OF JAPAN vol. 1998, no. 01, 30. Januar 1998 (1998-01-30) & JP 09 232099 A (HITACHI LTD;HITACHI KASADO ENG KK), 5. September 1997 (1997-09-05)
- PATENT ABSTRACTS OF JAPAN vol. 1998, no. 13, 30. November 1998 (1998-11-30) & JP 10 223398 A (TOKYO ELECTRON LTD), 21. August 1998 (1998-08-21)

## Beschreibung

Die Erfindung betrifft ein Verfahren gemäß dem Oberbegriff des Patentanspruchs 1 sowie eine Vorrichtung gemäß dem Oberbegriff des Patentanspruchs 8.

Besondere, aber nicht ausschließliche Bedeutung kommt der Beschichtung von gewölbten Oberflächen von Brillengläsern oder Linsen mit einer oder mehreren Schichten, speziell mit Antikratzschichten und uniformen, reflexverminderten Vielfachschichten zu.

Gemäß der DE 39 31 713 C1 werden Werkstücke, insbesondere Kunststofflinsen, beidseitig mit einer abriebfesten Schutzschicht versehen, indem man sie bezüglich des elektrischen Potentials freischwebend in den Mittenbereich eines durch zwei Elektroden gebildeten Entladungsraums einbringt. Denn im sogenannten Plasmaraum ist die Ladungsdichteverteilung weitestgehend abstandsunabhängig im Gegensatz zu den Dunkelräumen unmittelbar an den Elektroden. Die Gasentladung wird durch das Anlegen eines Radiofrequenz-Feldes zwischen den Elektroden erzeugt. Dieses Verfahren hat den Nachteil, daß die beiden Seiten des Substrates unterschiedlich beschichtet werden, da eine Seite immer der geerdeten Elektrode zugewandt ist und dort das Plasma andere Eigenschaften aufweist als in der Nähe der die Radiofrequenz einkoppelnden Elektrode.

Die Anmeldung WO 96/27690 beschreibt ein PECVD-Verfahren ("Plasma Enhanced Chemical Vapor Deposition"-Verfahren) sowie eine Vorrichtung zur beidseitigen Beschichtung von Substraten, vorzugsweise von Brillengläsern, durch Mikrowellenanregung. Dafür wird für jede zu beschichtende Fläche in distinktes Plasma verwendet. Um die Wärmebelastung des Substrates niedrig zu halten, wird die Anwendung einer gepulsten Entladung empfohlen. Es wird nicht darauf eingegangen, welche Uniformitäten in der Beschichtung erreicht werden können und wie diese beeinflußt werden können.

Die Anmeldung WO 95/26427 A1 beschreibt ein PICVD-Verfahren sowie eine Vorrichtung zur Herstellung von uniformen Beschichtungen auf Linsen aus Glas oder Kunststoff, bei dem die zu beschichtende Substratoberfläche gegenüber der Gasdurchlaßfläche einer Gasdusche angeordnet wird. In einer bevorzugten Ausführungsform ist die Gasdusche als Zonendusche ausgebildet, durch die sich örtlich unterschiedliche Gasflüsse auf das Substrat einstellen lassen. Für jede Substratform werden individuelle Mikrowellen- und Gasflußparameter verwendet. Es lassen sich zwar auch für Antireflexbeschichtungen hinreichende Uniformitäten erreichen, allerdings ist die Ermittlung der individuellen Prozeßparameter und ihre Steuerung sehr aufwendig.

In der DE 196 52 454 A1 sind ein Verfahren und eine Vorrichtung zur Außenbeschichtung von Lampen beschrieben. Eine Beschädigung der zu beschichtenden Lampe durch die Mikrowellen wird dadurch verhindert, daß die in den Mikrowellenreaktor eingekoppelte Mikrowellenleistung größer gleich einem Schwellenwert gewählt wird, bei dem sich ein Plasma mit verminderter Durchlässigkeit für Mikrowellenstrahlung einstellt. Die Mikrowellen werden also durch das Plasma abgeschirmt. Über erreichbare Schichtuniformitäten findet sich keine Aussage.

In der US 5,645,645 wird ein Diamantbeschichtungsverfahren zum partiellen Diamantbeschichten von Bohrern und Dichtringen mittel UHF oder Mikrowellen beschrieben.

Die EP 0 326 998 B1 beschreibt ein Verfahren zur Mikrowellen-CVD-Beschichtung von ebenen Substraten.

In den Vorrichtungen gemäß US 5,645,645 oder der EP 0 326 998 B1 liegt ein Zusammenspiel aus herkömmlichen Abstimmelementen in Form von metallischen Schiebern und perforierten Metallplatten vor. Die herkömmlichen Abstimmelemente dienen der Impedanzanpassung, was zu einer höheren Mikrowellenintensität führt. Die Mikrowellenfeinverteilung wird dadurch nicht in ihrer Struktur verändert sondern lediglich verschoben bzw. intensiviert. In der EP 0 326 998 B1 dient die perforierte Metallplatte lediglich zur Streuung des Reaktionsflusses. In der Vorrichtung gemäß US 5,645,645 bildet die perforierte Platte die Einkoppelstelle für das Plasma und hat auf die Mikrowellen eine einer Blende ähnliche Wirkung.

Die Aufgabe der Erfindung besteht darin, ein Verfahren und eine Vorrichtung bereitzustellen, um insbesondere gekrümmte Substrate, wie z.B. Linsen und Brillengläser, in wirtschaftlicher Weise beschichten zu können, wobei eine hohe Schichtdickenuniformität erzielt werden soll. Die Uniformität sollte ca. ± 1 % betragen, um hinreichend gut für die Beschichtung mit Antikratz- und Antireflexschichten zu sein. Dabei ist die Uniformität definiert als 100 % multipliziert mit der Standardabweichung der Durchschnittsschichtdicke dividiert durch die Schichtdicke.

Diese Aufgabe wird mit einem Verfahren gemäß Anspruch 1 sowie durch eine Vorrichtung gemäß Anspruch 8 gelöst.

Eine Grunduniformität der Schichtdicke wird gewährleistet, indem sich die zu beschichtende Substratfläche in einem Bereich des Plasmas befindet, in dem das Plasma undurchlässig für die Mikrowellen ist und die Plasmadichteverteilung in erster Näherung konstant ist. Der abschirmenden Wirkung des Plasmas kommt beim beid- oder mehrseitigen Beschichten zusätzliche Bedeutung zu, da durch die Abschirmung gewährleistet wird, daß die beiden Mikrowellenfelder einander nicht beeinflussen bzw. jedes Mikrowellenfeld nur das jeweilige Plasma beeinflußt.

Inhomogenitäten im Mikrowellenfeld rufen Inhomogenitäten in der Plasmadichteverteilung hervor. Durch das Einbringen von dielektrischen Abstimmelementen in das Mikrowellenfeld im Bereich der Mikrowelleneinkoppelstellen kann man Einfluß auf die Mikrowellenfeldverteilung nehmen. An der Oberfläche des dielektrischen Abstimmelementes ändert sich die Phase der Mikrowelle. Außerdem wird das Mikrowellenfeld abgeschwächt und die Ausbreitungsgeschwindigkeit der Welle ist innerhalb des dielektrischen Abstimmelementes geringer. Dies modifiziert die elektrische Feldverteilung und als Folge auch die davon abhängende Plasmadichteverteilung und das dadurch induzierte Beschichtungsergebnis. Durch Wahl der Form der dielektrischen Abstimmelemente werden Beschichtungen erreicht, die eine Uniformität von etwa ± 1 % aufweisen.

Bei der Beschichtung einer konkaven Fläche ist in einem weiten Parameterbereich die Beschichtung an den Rändern größer als in der Mitte. Mit zunehmendem Abstand von der Mikrowelleneinkoppelstelle wird die Beschichtung gleichförmiger. Bei konvexen Flächen wird die Beschichtung bis zu einem gewissen Abstand gleichförmiger. Vergrößert man den Abstand noch weiter, nimmt die Gleichförmigkeit der Beschichtung wieder ab.

Das dielektrische Abstimmelement sollte verstärkt dort Material aufweisen, wo das Mikrowellenfeld abgeschwächt werden soll, d.h. wo eine Schichtdickenüberhöhung vermieden werden soll.

Vorteilhafterweise wird das Abstimmelement hinter der Einkoppelstelle der Mikrowellen im Mikrowellenhohlleiter angeordnet. Während des Verfahrens verbleibt das Abstimmelement vorzugsweise an diesem Ort.

Vorzugsweise wird das erfindungsgemäße Verfahren mittels eines Mikrowellen-PICVD-Verfahrens (Mikrowellen-"Plasma Induced Chemical Vapor Deposition"-Verfahren) durchgeführt. Dabei hat es sich als vorteilhaft erwiesen, die Abstände zwischen Substratfläche und Mikrowelleneinkoppelstelle in Abhängigkeit der Prozeßparameter Mikrowellenleistung, Druck, Mikrowellenpulsdauer und Mikrowellenpulspause sowie die Dauer der Mikrowellenimpulspausen in Abhängigkeit des Drucks, des Massenflusses des Reaktionsgases und des Abstandes Substratfläche/Mikrowelleneinkoppelstelle zu aktivieren. Dabei bedient man sich des Verfahrens der statistischen Versuchsplanung, wie dies z.B. beschrieben wird in: Box G.E.P., Hunter W.G., Hunter J.S.: Statistics for Experimenters, 1978, Wiley, N.Y.

Im allgemeinen werden dabei die jeweils relevanten Variablen in Abhängigkeit von der Oberfläche des zu beschichtenden Substrates frei variiert und die einzelnen Parameter dann bei Konstanthaltung der übrigen vorgegebenen Parameter nach Maßgabe mit der erzielten jeweiligen Ergebnisse für uniforme Beschichtung optimiert. Diese Maßnahme wird zur Reduzierung des experimentellen Aufwandes nur für Grenzformen der Linsen durchgeführt, und die Parameter für die Beschichtung der Zwischenform werden durch Interpolation ermittelt.

So wird beispielsweise für einen bestimmten Substrattyp in einer ersten Versuchsreihe unter Konstanthaltung jeweils drei der Parameter in einer ersten Versuchsreihe Mikrowellenleistung, Druck, Mikrowellenpulsdauer und Mikrowellenpause und freier Variation des/der Abstände Substrat/Mikrowelleneinkoppelstelle der jeweils vierte Parameter nach Maßgabe der erzielten jeweiligen Ergebnisse für eine uniforme Beschichtung optimiert.

Es ist auch möglich, für einen bestimmten Substrattyp in einer zweiten Versuchsreihe unter Konstanthaltung jeweils zwei der Parameter Druck, Reaktionsmassenfluß und Abstand/Abstände Substrat/Mikrowelleneinkoppelstelle und freier Variation der Mikrowellenimpulspausen den jeweils dritten Parameter nach Maßgabe der erzielten jeweiligen Ergebnisse für uniforme Beschichtung zu optimieren.

Als vorteilhaft hat es sich erwiesen, bei kontinuierlichem Gasfluß zwischen Trägergas und Reaktionsgas und umgekehrt umzuschalten, ohne den Gasfluß zu unterbrechen. Während des kontinuierlichen Gasflusses wird das Plasma durch Mikrowellen gezündet.

Vorzugweise wird das Gas möglichst nah an der zu beschichtenden Fläche eingeführt. Je näher an der Substratfläche das Gas zugeführt wird, desto kürzer können die Impulspausen gewählt werden. Auch die Impulsdauer sollte möglichst kurz gewählt werden, damit die Gasströmung während des Mikrowellenimpulses als ruhend angesehen werden kann. Dies erleichtert eine Modellierung des Beschichtungsvorganges.

Bevorzugte Reaktionsgase sind Hexamethyldisiloxan und Titantetrachlorid.

Die dielektrischen Abstimmelemente, die im Bereich der Mikrowelleneinkoppelstellen in der erfindungsgemäßen Vorrichtung angeordnet sind, bestehen vorzugsweise aus Materialien mit sehr hoher Dielektrizitätskonstante. Besonders bevorzugt werden als Materialien Quarz und Polytetrafluorethylen.

Vorzugsweise sind die dielektrischen Abstimmelemente auf der atmosphärischen Seite der Einkoppelstellen und auf dem oder den Mikrowellenfenstern angebracht.

In einer bevorzugten Ausführungsform entspricht die Außenkontur des dielektrischen Abstimmelementes dem Innendurchmesser des Hohlleiters, in dem es angebracht wird.

Die Gestalt der dielektrischen Abstimmelemente wird vorteilhafterweise an die zu beschichtende Substratoberfläche und die gewünschte Beschichtungsdicke angepaßt. Das dielektrische Abstimmelement kann als Ring oder Scheibe oder auch Kegel oder Pyramide ausgebildet sein. Man kann auch Kombinationen verschiedener dielektrischer Abstimmelemente verwenden, wie z.B. eine Scheibe mit einem Ring oder auch zwei Scheiben unterschiedlichen Durchmessers, die jeweils koaxial zueinander angeordnet sind. Je nach Mikrowellenleistung, Krümmung der zu beschichtenden Oberfläche und gewünschter Beschichtung weisen die dielektrischen Abstimmelemente eine Materialdicke von 5 bis 50 mm auf.

Vorteilhafterweise ist der Gaseinlaß am Substrathalter angebracht.

Der Abstand zwischen Substrathalter und Mikrowelleneinkoppelstelle sollte so gewählt werden, daß der Abstand zwischen zu beschichtender Fläche und Einkoppelstelle zwischen 5 und 80 mm beträgt.

Die Erfindung soll anhand der nun folgenden Figuren näher erläutert werden.

Dabei zeigen
- Fig. 1a: eine Prinzipskizze der erfindungsgemäßen Vorrichtung zur Beschichtung eines plankonvexen Substrats,
- Fig. 1b: eine Prinzipskizze der erfindungsgemäßen Vorichtung zur Beschichtung eines konvexen Substrats und
- Fign. 2a+b: die gemessene Schichtdickenverläufe.

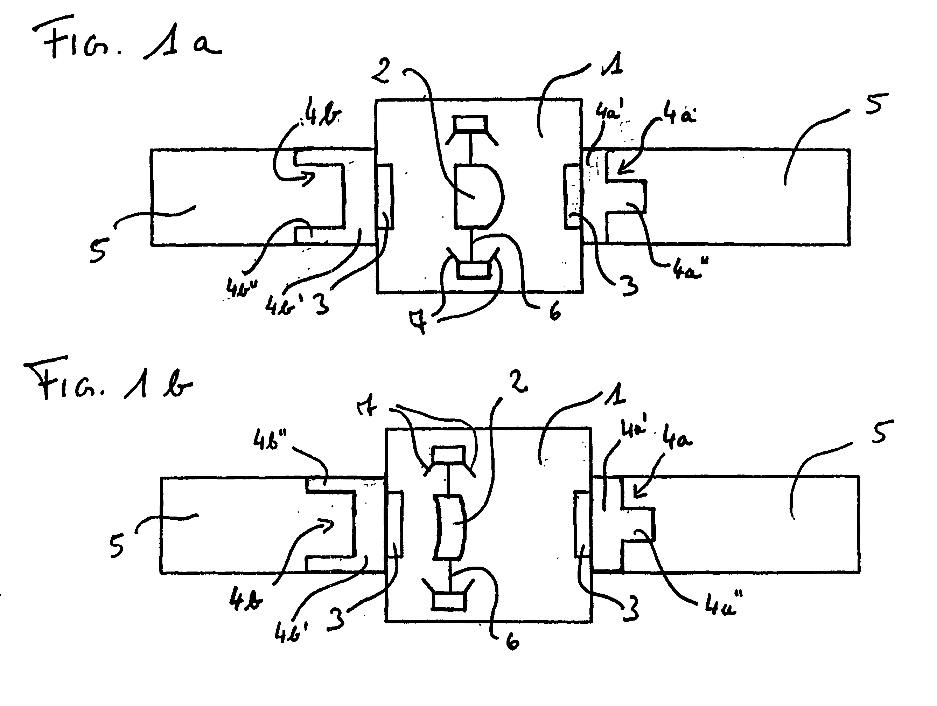

In Fig. 1 ist eine erfindungsgemäße Vorrichtung zum beidseitigen Beschichten eines gewölbten Substrates dargestellt. Sie weist einen Beschichtungsreaktor 1 auf, in dem das Substrat 2 mittels eines Substrathalters 6 befestigt ist. In unmittelbarer Nähe des Substrathalters 6 sind Gaseinlässe 7 angeordnet. Im vorliegenden Fall ist die Gaszufuhr als rotationssymmetrische Gasdusche ausgebildet. Der Gasauslaß ist wegen der besseren Übersichtlichkeit nicht dargestellt. Das Substrat 2 ist auf einer Seite konvex und auf der anderen Seite plan. Das Substrat 2 ist derart im Beschichtungsreaktor 1 angeordnet, daß die zu beschichtenden Flächen parallel zu den Mikrowellenfenstern 3 sind. An die Mikrowellenfenster 3 schließen sich beidseitig Mikrowellenhohlleiter 5 an.

Auf der atmosphärischen Seite der Mikrowelleneinkoppelstellen 3, also in den Hohlleitern 5, sind dielektrische Abstimmelemente 4a,b angebracht. Das dielektrische Abstimmelement 4a auf der konvexen Seite des Substrates 2 ist aus zwei Teilelementen 4a' und 4a" aufgebaut. Dabei handelt es sich um eine Scheibe 4a', deren Außendurchmesser dem Innendurchmesser des Hohlleiters 5 entspricht und einer Scheibe 4a" kleineren Durchmessers, die koaxial auf der größeren Scheibe 4a' angebracht ist und dadurch das Mikrowellenfeld und die Plasmaverteilung im Bereich der Mitte der konvexen Substratfläche abschwächt. Das dielektrische Abstimmelement 4b, das der planaren Seite des Substrates 2 gegenüberliegt, wobei die planare Seite als Grenzfall für konkave Flächen betrachtet wird, besteht aus einer Scheibe 4b', deren Außendurchmesser dem Innendurchmesser des Hohlraumleiters 5 analog zur Scheibe 4a' entspricht und einem Ringelement 4b". Dadurch wird die Mikrowellenfeldverteilung und Plasmadichteverteilung am Rand des Substrates geschwächt. Die dielektrischen Abstimmelemente 4a,b werden bis zum Anschlag am jeweiligen Mikrowellenfenster 3 in den jeweiligen Hohlleiter 5 eingeschoben.

Es hat sich im übrigen herausgestellt, daß vorteilhafterweise das Substrat 2 im Beschichtungsreaktor 1 außermittig anzuordnen ist, insbesondere wenn das Substrat 2 wie in Fig. 1b auf einer Seite konkav und auf der anderen Seite konvex ist. Dabei sollte die konkave Fläche einen größeren Abstand zur Mikrowelleneinkoppelstelle 3 aufweisen als die konvexe Fläche. Dies ist in Fig. 1b dargestellt. Im übrigen ist der Aufbau in Fig. 1b analog zu dem in Fig. 1a.

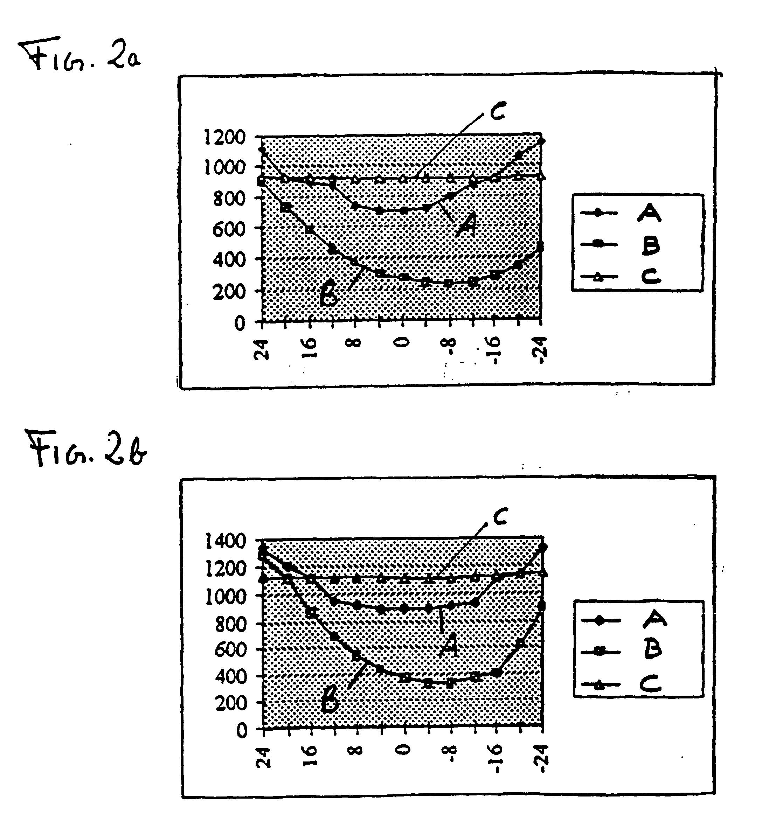

Es sind Messungen der Beschichtung einer konkaven Fläche in zwei verschiedenen Abständen von der Mikrowelleneinkoppelstelle durchgeführt worden. Die Ergebnisse sind in den Fign. 2a und 2b dargestellt. Auf der Abszisse ist die Ortskoordinate in radialer Richtung auf dem Substrat dargestellt, wobei der Nullpunkt im Mittelpunkt der Substratfläche liegt. Auf der Ordinate sind die entsprechenden Schichtdicken aufgetragen: Die Messungen wurden einmal ohne dielektrisches Abstimmelement (Meßpunkte A) durchgeführt, einmal mit einem scheibenförmigen dielektrischen Abstimmelement (Meßpunkte B), wobei die Scheibe derart dimensioniert ist, daß das Feld in der Mitte der zu beschichtenden Fläche geschwächt wird, und mit einem ringförmigen dielektrischen Abstimmelement (Meßpunkte C), das das Feld am Rand der zu beschichtenden Fläche schwächt. Die Messung, die in Fig. 2a dargestellt ist, zeigt eine Beschichtung, bei der die konkave Substratfläche 34 mm von der Mikrowelleneinkoppelstelle entfernt war. Gemessen wird der Abstand immer bezüglich der kürzesten Entfernung, d.h. bei konkaven Linsen vom Linsenrand aus und bei konvexen Linsen von der Linsenmitte aus. Bei der Messung in Fig. 2b war die konkave Substratfläche 39 mm von der Mikrowelleneinkoppelstelle entfernt. Die Uniformität ist definiert als 100 % multipliziert mit der Standardabweichung der Durchschnittsschichtdicke dividiert durch die Schichtdicke.

In beiden Messungen ist die Beschichtung ohne dielektrisches Abstimmelement sehr inhomogen. An den Rändern des konkaven Substrates sind die Schichtdicken viel größer als in der Mitte des konkaven Substrates.

Verwendet man ein dielektrisches Abstimmelement, das das Feld in der Mitte der zu beschichtenden Fläche schwächt (Meßpunkt B), wird dieser Effekt sogar verstärkt. Wird hingegen ein ringförmiges dielektrisches Abstimmelement im Hohlleiter an der Mikrowelleneinkoppelstelle angeordnet, so daß das Feld am Rand des zu beschichtenden Substrates geschwächt wird, wird eine konstante Schichtdicke über das gesamte konkave Substrat erreicht.

### Bezugszeichen

- 1: Beschichtungsreaktor
- 2: Substrat
- 3: Mikrowellenfenster
- 4a,4a',4a'': dielektrisches Abstimmelement
- 4b,4b',4b'': dielektrisches Abstimmelement
- 5: Mikrowellenhohlleiter
- 6: Substrathalter
- 7: Gaseinlaß
- 8: Gasauslaß
- A: Messung ohne dielektrisches Element
- B: Messung mit ringförmigem dielektrischen Element
- C: Messung mit scheibenförmigem dielektrischen Element

## Patentansprüche

1. Verfahren zum ein- oder mehrseitigen Beschichten von insbesondere gekrümmten Substraten in einem Mikrowellenreaktor mittels eines Mikrowellenplasma-CVD-Verfahrens, bei dem die in den Mikrowellenreaktor eingekoppelte Mikrowellenleistung größer gleich einem Schwellenwert gewählt wird, bei dem sich ein Plasma mit verminderter Durchlässigkeit für Mikrowellenstrahlung einstellt, und bei dem für jeweils eine zu beschichtende Fläche ein eigenes Plasma eingesetzt wird, das an jeweils einer Mikrowelleneinkoppelstelle eingekoppelt wird, und die zu beschichtende(n) Fläche(n) senkrecht zur Ausbreitungsrichtung des beschichtenden Plasmas angeordnet werden, **dadurch gekennzeichnet,**
**daß** der Abstand zwischen der/den zu beschichtenden Substratflächen und der/den jeweiligen Einkoppelstellen größer als die Eindringtiefe der Mikrowellen in das Plasma eingestellt wird und daß durch das Einbringen von einem oder mehreren dielektrischen Abstimmelementen in das Mikrowellenfeld im Bereich der Mikrowelleneinkoppelstelle(n) die Mikrowellenfeldverteilung derart beeinflußt wird, daß in der Plasmadichteverteilung bestehende Inhomogenitäten korrigiert werden.

2. Verfahren nach Anspruch 1, **dadurch gekennzeichnet, daß** ein PICVD-Verfahren verwendet wird.

3. Verfahren nach Anspruch 2, **dadurch gekennzeichnet, daß** der/die Abstände Substrat/Mikrowelleneinkoppelstelle in Abhängigkeit der Mikrowellen-PICVD-Prozeßparameter Mikrowellenleistung, Druck, Mikrowellenpulsdauer, Mikrowellenpulspause durch statistische Versuchsplanung optimiert werden.

4. Verfahren nach Anspruch 2 oder 3, **dadurch gekennzeichnet, daß** die Dauer der Mikrowellenimpulspausen in Abhängigkeit des Drucks, des Reaktionsgasmassenflusses und des/der Abstände Substrat-Mikrowelleneinkoppelstellen durch statistische Versuchsplanung optimiert werden.

5. Verfahren nach einem der Ansprüche 2 bis 4, **dadurch gekennzeichnet, daß** Trägergas und Reaktionsgas im wesentlichen kontinuierlich einströmen und lediglich zwischen Trägergas und Reaktionsgas umgeschaltet wird.

6. Verfahren nach einem der Ansprüche 2 bis 5, **dadurch gekennzeichnet, daß** Trägergas und Reaktionsgas möglichst nah an der/den zu beschichtenden Fläche(n) eingeführt werden.

7. Verfahren nach einem der vorhergehenden Ansprüche, **dadurch gekennzeichnet, daß** das Reaktionsgas Hexamethyldisiloxan oder Titantetrachlorid verwendet wird.

8. Vorrichtung zum mehrseitigen Beschichten von insbesondere gewölbten Substraten mittels einem Mikrowellenplasma-CVD-Verfahrens mit
- einer Reaktionskammer (1), die mindestens eine Gaszuführung (7) und eine Gasabführung (8) aufweist,
- mindestens zwei in der Reaktionskammerwandung angeordneten Mikrowellenfenstern (3),
- mindestens zwei Mikrowellenhohlleitern (5) mit Mikrowelleneinkoppelstelle,
- dielektrischen Abstimmelementen (4a,4a',4a",4b,4b',4b"), die im Bereich der Mikrowelleneinkoppelstellen angeordnet sind und die Mikrowellenfeldverteilung beeinflussen und
- einem oder mehreren derart in der Reaktionskammer (1) angeordneten Substrathaltern (6), daß die zu beschichtenden Flächen senkrecht zur Ausbreitungsrichtung des zu beschichtenden Plasmas ausgerichtet sind und daß der Abstand zwischen den zu beschichtenden Substratflächen und der jeweiligen Einkoppelstellen größer als die Eindringtiefe der Mikrowellen in das Plasma ist.

9. Vorrichtung nach Anspruch 8, **dadurch gekennzeichnet, daß** das oder die dielektrischen Abstimmelemente (4a,b) aus Quarz oder PTFE gefertigt sind.

10. Vorrichtung nach Anspruch 8 oder 9, **dadurch gekennzeichnet, daß** das oder die dielektrischen Abstimmelemente (4a,b) auf der atmosphärischen Seite der Einkoppelstelle(n) angeordnet sind.

11. Vorrichtung nach einem der Ansprüche 8 bis 10, **dadurch gekennzeichnet, daß** das oder die dielektrischen Abstimmelemente (4a,b) auf dem oder den Mikrowellenfenstern (3) angeordnet sind.

12. Vorrichtung nach einem der Ansprüche 8 bis 11, **dadurch gekennzeichnet, daß** die Außenkontur des oder der dielektrischen Abstimmelemente (4a,b) der Innenkontur des jeweiligen Mikrowellenhohlleiters (5) entspricht.

13. Vorrichtung nach einem der Ansprüche 8 bis 12, **dadurch gekennzeichnet, daß** das oder die dielektrischen Abstimmelemente (4a,b) als Ring (4b"), Scheibe (4b',4a',4a"), Kegel, Pyramide oder einer Kombination der vorgenannten geometrischen Formen ausgebildet sind.

14. Vorrichtung nach einem der Ansprüche 8 bis 13, **dadurch gekennzeichnet, daß** der Gaseinlaß (7) benachbart zum Substrathalter (6) angeordnet ist.

15. Vorrichtung nach einem der Ansprüche 8 bis 14, **dadurch gekennzeichnet, daß** der Abstand Substrathalter (6) - Mikrowellenfenster (3) zwischen 5 und 80 mm beträgt.

## Claims

1. Process for coating one or more sides of in particular curved substrates in a microwave reactor by means of a microwave plasma CVD process, in which the microwave power introduced into the microwave reactor is selected to be greater than or equal to a threshold value at which a plasma with a reduced transmission for microwave radiation is established, and in which a dedicated plasma, which is introduced at a respective microwave introduction location, is used for each surface to be coated, and the surface(s) to be coated are arranged perpendicular to the propagation direction of the coating plasma, **characterized in that** the distance between the substrate surface(s) to be coated and the respective introduction location(s) is set to be greater than the depth of penetration of the microwaves into the plasma, and **in that** the microwave field distribution is influenced by the introduction of one or more dielectric tuning elements into the microwave field in the region of the microwave introduction location(s) in such a manner that inhomogeneities in the plasma density distribution are corrected.

2. Process according to Claim 1, **characterized in that** a PICVD process is used.

3. Process according to Claim 2, **characterized in that** the substrate/microwave introduction location distance(s) are optimized by statistical test planning as a function of the microwave PICVD process parameters microwave power, pressure, microwave pulse duration, microwave interpulse period.

4. Process according to Claim 2 or 3, **characterized in that** the duration of the microwave interpulse periods are optimized by statistical test planning as a function of the pressure, mass flow of reaction gas and/or the substrate-microwave introduction location distance(s).

5. Process according to one of Claims 2 to 4, **characterized in that** carrier gas and reaction gas flow in substantially continuously, and the process is merely switched between carrier gas and reaction gas.

6. Process according to one of Claims 2 to 5, **characterized in that** carrier gas and reaction gas are introduced as close as possible to the surface(s) to be coated.

7. Process according to one of the preceding claims, **characterized in that** the reaction gas hexamethyldisiloxane or titanium tetrachloride is used.

8. Apparatus for multi-side coating of in particular curved substrates by means of a microwave plasma CVD process, having
- a reaction chamber (1) which includes at least one gas feed (7) and a gas discharge (8),
- at least two microwave windows (3) arranged in the reaction chamber wall,
- at least two microwave waveguides (5) with microwave introduction location,
- dielectric tuning elements (4a, 4a', 4a'', 4b', 4b', 4b''), which are arranged in the region of the microwave introduction locations and influence the microwave field distribution, and
- one or more substrate holders (6) which are arranged in such a manner in the reaction chamber (1) that the surfaces to be coated are oriented perpendicular to the propagation direction of the coating plasma, and that the distance between the substrate surfaces to be coated and the respective introduction locations is greater than the depth of penetration of the microwaves into the plasma.

9. Apparatus according to Claim 8, **characterized in that** the dielectric tuning element (s) (4a, b) are made from quartz or PTFE.

10. Apparatus according to Claim 8 or 9, **characterized in that** the dielectric tuning element (s) (4a, b) are arranged on the atmospheric side of the introduction location(s).

11. Apparatus according to one of Claims 8 to 10, **characterized in that** the dielectric tuning element(s) (4a, b) are arranged on the microwave window(s) (3).

12. Apparatus according to one of Claims 8 to 11, **characterized in that** the external contour of the dielectric tuning element(s) (4a, b) corresponds to the internal contour of the respective microwave waveguide (5).

13. Apparatus according to one of Claims 8 to 12, **characterized in that** the dielectric tuning element(s) (4a, b) are designed as a ring (4b''), a disc (4b', 4a', 4a''), a cone, pyramid or a combination of these geometric shapes.

14. Apparatus according to one of Claims 8 to 13, **characterized in that** the gas inlet (7) is arranged adjacent to the substrate holder (6).

15. Apparatus according to one of Claims 8 to 14, **characterized in that** the substrate holder (6) - microwave window (3) distance is between 5 and 80 mm.

## Revendications

1. Procédé pour recouvrir un ou plusieurs côtés de substrats et en particulier de substrats courbes dans un réacteur à micro-ondes par un procédé de dépôt chimique de vapeur (CVD) par plasma de micro-ondes, dans lequel la puissance micro-ondes du réacteur à micro-ondes est supérieure ou égale à une valeur de seuil, dans lequel on sélectionne un plasma qui laisse peu passer le rayonnement micro-ondes, dans lequel, pour chaque surface à recouvrir, on utilise un plasma particulier qui est injecté chaque fois l'un emplacement d'entrée des micro-ondes et dans lequel la ou les surfaces à recouvrir sont agencées perpendiculairement à la direction de propagation du plasma de recouvrement, **caractérisé en ce que** la distance entre la ou les surfaces de substrat à recouvrir et le ou les emplacements respectifs d'entrée est supérieure à la profondeur de pénétration des micro-ondes dans le plasma et **en ce que** l'on agit sur la répartition du champ de micro-ondes de manière à corriger les inhomogénéités de répartition de la densité du plasma, un ou plusieurs éléments diélectriques de mise au point étant montés dans le champ de micro-ondes dans la zone du ou des emplacements d'entrée des micro-ondes.

2. Procédé selon la revendication 1, **caractérisé en ce que** l'on utilise un procédé PICVD ("Plasma Impulse Chemical Vapour Deposition" - dépôt chimique de vapeur par plasma pulsé).

3. Procédé selon la revendication 2, **caractérisé en ce que** la ou les distances entre le substrat et les emplacements d'entrée des micro-ondes sont optimisées en planifiant des essais statistiques en fonction des paramètres du processus de PICVD à micro-ondes que sont la puissance des micro-ondes, la pression, la durée des impulsions des micro-ondes et la durée des pauses entre les impulsions des micro-ondes.

4. Procédé selon les revendications 2 ou 3, **caractérisé en ce que** la durée des pauses entre les impulsions des micro-ondes est optimisée en planifiant des essais statistiques en fonction de la pression, du débit massique de gaz de réaction et de la ou des distances entre le substrat et les emplacements d'entrée des micro-ondes.

5. Procédé selon l'une des revendications 2 à 4, **caractérisé en ce que** le gaz porteur et le gaz de réaction sont introduits essentiellement en continu, l'alternance ne se faisant qu'entre le gaz porteur et le gaz de réaction.

6. Procédé selon l'une des revendications 2 à 5, **caractérisé en ce que** le gaz porteur et le gaz de réaction sont introduits le plus près possible de la ou des surfaces à recouvrir.

7. Procédé selon l'une des revendications précédentes, **caractérisé en ce que** le gaz de réaction est de l'hexaméthyldisiloxane ou du tétrachlorure de titane.

8. Dispositif pour recouvrir plusieurs côtés de substrats et en particulier de substrats convexes au moyen d'un procédé de CVD par plasma de micro-ondes, qui présente :
- une chambre de réaction (1) munie d'au moins une amenée (7) de gaz et d'au moins une évacuation (8) de gaz,
- au moins deux fenêtres (3) à micro-ondes agencées dans la paroi de la chambre de réaction,
- au moins deux conduits creux (5) à micro-ondes dotés d'emplacements d'entrée des micro-ondes,
- des éléments diélectriques de réglage (4a, 4a', 4a'', 4b, 4b', 4b'') qui sont agencés dans la région des emplacements d'entrée des micro-ondes et qui agissent sur la répartition du champ de micro-ondes et
- une ou plusieurs fixations (6) de substrat agencées dans la chambre (1) de réaction de telle façon que les surfaces à recouvrir soient orientées perpendiculairement à la direction de propagation du plasma de recouvrement et de telle manière que la distance entre les surfaces du substrat à recouvrir et les emplacements respectifs d'entrée soit supérieure à la profondeur de pénétration des micro-ondes dans le plasma.

9. Dispositif selon la revendication 8, **caractérisé en ce que** les éléments diélectriques (4a, b) de réglage sont réalisés en quartz ou en PTFE.

10. Dispositif selon les revendications 8 ou 9, **caractérisé en ce que** le ou les éléments diélectriques (4a, b) de mise au point sont agencés sur le côté atmosphérique du ou des emplacements d'entrée.

11. Dispositif selon l'une des revendications 8 à 10, **caractérisé en ce que** le ou les éléments diélectriques (4a, b) de réglage sont agencés sur la ou sur les fenêtres (3) à micro-ondes.

12. Dispositif selon l'une des revendications 8 à 11, **caractérisé en ce que** le contour extérieur du ou des éléments diélectriques (4a, b) de réglage correspond au contour intérieur de la conduite creuse (5) micro-ondes respective.

13. Dispositif selon l'une des revendications 8 à 12, **caractérisé en ce que** le ou les éléments diélectriques (4a, b) de réglage sont des anneaux (4b''), des disques (4b', 4a', 4a''), des cônes, des pyramides ou des combinaisons de ces formes géométriques.

14. Dispositif selon l'une des revendications 8 à 13, **caractérisé en ce que** l'admission (7) de gaz est agencée au voisinage de la fixation (6) de substrat.

15. Dispositif selon l'une des revendications 8 à 14, **caractérisé en ce que** la distance entre les fixations (6) de substrat et les fenêtres (3) micro-ondes est comprise entre 5 et 80 mm.
